# EUROPÄISCHE PATENTANMELDUNG

(11) **EP 1 744 353 A1**
(43) Veröffentlichungstag der Anmeldung: **17.01.2007**
(21) Anmeldenummer: 06010108.6
(22) Anmeldetag: 16.05.2006
(51) Int. Cl.: H01L 21/48, H01L 23/14, H01L 23/48

(54) **Chip-Trägersubstrat aus Silizium mit durchgehenden Kontakten und Herstellungsverfahren dafür**

(30) Priorität: 15.07.2005 DE 102005033254
(71) Anmelder: Infineon Technologies AG, 81669 München (DE)
(72) Erfinder: Lehmann, Volker, Dr., 80689 München (DE); Binder, Florian, 82131 Buchendorf (DE); Haneder, Thomas, 85221 Dachau (DE); Martin, Alfred, 81825 München (DE)
(74) Vertreter: Müller-Boré & Partner Patentanwälte

(57) **Zusammenfassung**

Die vorliegende Erfindung beschreibt insbesondere ein Verfahren zur Herstellung eines Chip-Trägersubstrats aus Silizium mit durchgehenden Kontakten. Die vorliegende Erfindung stellt eine innovative Technologie-Plattform zur Herstellung von hoch integrierten "System in Package"-Modulen auf Basis von Silizium-Trägern dar und findet Anwendung im Bereich der Kommunikationstechnik sowie Automobil- und Industrieelektronik (z.B. Hochfrequenzmodule für Mobiltelefone, Basisstationen oder auch Radarmodule für Automobile) oder anderen Bereichen, in denen eine Höchstintegration aus Platz- oder Kostengründen erwünscht ist.

## Beschreibung

Die vorliegende Erfindung beschreibt insbesondere ein Verfahren zur Herstellung eines Chip-Trägersubstrats aus Silizium mit durchgehenden Kontakten. Die vorliegende Erfindung stellt eine innovative Technologie-Plattform zur Herstellung von hoch integrierten "System in Package"-Modulen auf Basis von Silizium-Trägern dar und findet Anwendung im Bereich der Kommunikationstechnik sowie Automobil- und Industrieelektronik (z.B. Hochfrequenzmodule für Mobiltelefone, Basisstationen oder auch Radarmodule für Automobile) oder anderen Bereichen, in denen eine Höchstintegration aus Platz- oder Kostengründen erwünscht ist.

"System in Package"-Module werden derzeit unter Verwendung verschiedener Träger-Materialien, wie beispielsweise LTCC Keramik, Laminat PCB, Glas oder Silizium, hergestellt. Eine Herausforderung bei Verwendung von Silizium-Trägern liegt in der Herstellung von sog. "Through Holes", d.h. Durchkontaktierungen im Träger. Verschiedene "Through Hole" Technologien sind heute zur Herstellung von Prototypen verfügbar. Ein wesentlicher Nachteil der bisherigen Konzepte liegt jedoch im großen technischen Aufwand und den damit verbundenen Herstellungskosten.

Ein besonderes Problem bei der Herstellung von solchen Chip-Trägersubstraten besteht dabei darin, die durch das Substrat führenden elektrischen Verbindungen zwischen beiden Seiten des Substrates, sogenannte Vias, herzustellen, d.h. durch das Substrat führende Löcher mit Metall zu füllen. Die Füllung von Vias mit Metall wird mit größer werdendem Aspektverhältnis, d.h. mit abnehmendem Durchmesser und zunehmender Tiefe, immer schwieriger. Berechnungen zeigen aber, dass Vias mit großem Aspektverhältnis besonders erstrebenswert sind. In vielen anwendungsrelevanten Fällen ist es nämlich für die elektrischen Eigenschaften besonders vorteilhaft, statt eines Kontaktloches mit z.B. 100 µm Durchmesser mehrere kleinere Kontaktlöcher z.B. mit einem Durchmesser von 10 µm parallel zu schalten. Dies verbessert die elektrische Leitfähigkeit der Vias immer dann, wenn Wechselspannung bzw. Wechselstrom, wie es beispielsweise bei hochfrequenten Signalen der Fall ist, durch das Substrat geführt werden soll. In diesem Fall steht auf Grund des sog. Skin-Effekts nur noch der oberflächennahe Bereich des Leiters, also des Vias, für den Signaltransport zur Verfügung. Die Parallelschaltung mehrerer kleinerer Vias stellt insofern einen großen Vorteil dar, da mehr Oberfläche für den Signaltransport zur Verfügung gestellt wird als bei einem großen Via, was besonders die Hochfrequenzeigenschaften im GHz-Bereich deutlich verbessert. Im Bereich von einigen 10 GHz wird eine elektrisch gute Durchkontaktierung überhaupt erst durch die Parallelschaltung mehrerer Vias ermöglicht.

Ein weiteres Problem bei der Verwendung eines leitfähigen Substratmaterials wie Silizium liegt in der Herstellung einer Isolatorschicht, welche die durch das Substrat gehenden Kontakte äußerst zuverlässig sowohl gegeneinander als auch gegen das Substrat selbst isoliert. Normalerweise würde man den Prozess so führen, dass zunächst mit Metall gefüllte Sacklöcher im Substrat erzeugt werden und durch Rückätzen oder Schleifen des Substrates ein Teil des Substratmaterials von der Rückseite aus entfernt wird, um die Kontaktlöcher von der Rückseite aus zu öffnen und zugänglich zu machen. Insbesondere beim Rückschleifen des Materials tritt dabei das Problem auf, dass durch Verschmieren des Metalls aus den Kontaktlöchern auf der Rückseite des Substrates ein Kurzschluss zwischen Kontaktlöchern oder Kontaktlöchern und Substrat entstehen kann, was zum Ausfall des Chip-Trägersubstrates führt. Auch beim Rückätzen kann nicht ausgeschlossen werden, dass eine elektrisch leitende Verbindung zwischen Metall im Kontaktloch und Substrat entsteht. Bei dieser Art der Prozessführung wird die Isolatorschicht auf der Rückseite des Substrates nämlich immer nach Füllung der Kontaktlöcher mit Metall erzeugt; d.h. das Entstehen eines unbeabsichtigten Kurzschlusses zwischen dem Metall in den Kontaktlöchern oder dem Metall in den Kontaktlöchern und dem Substrat auf der Rückseite des Chip-Trägersubstrates, der zum Ausfall des Chip-Trägersubstrates führt, kann durch die Isolatorschicht auf der Rückseite nicht verhindert werden. Dieses Problem kann zu erheblichen Ausbeute-Problemen bei der Herstellung solcher Chip-Trägersubstrate führen.

Der vorliegenden Erfindung liegt somit die Aufgabe zugrunde, im Rahmen der Bereitstellung solcher "System in Package"-Module die Durchkontaktierungen des hierfür eingesetzten Trägermaterials mit guter elektrischer Leitfähigkeit und in kostengünstiger, effizienter Art und Weise zu bewerkstelligen. Insbesondere liegt der vorliegenden Erfindung auch die Aufgabe zu Grunde, ein Verfahren anzugeben, das die Füllung der Kontaktlöcher mit Metall auch bei kleinen Lochdurchmessern effizient und kostengünstig erlaubt, d.h. mit Metall gefüllte Kontaktlöcher mit großem Aspektverhältnis zu realisieren. Der vorliegenden Erfindung liegt die weitere Aufgabe zu Grunde, eine Prozessführung anzugeben, welche die Herstellung einer Isolatorschicht auf allen Oberflächen des Chip-Trägersubstrates erlaubt, bevor die Kontaktlöcher mit Metall gefüllt werden.

Diese Aufgabe wird durch die in den Ansprüchen gekennzeichneten Ausführungsformen gelöst.

Insbesondere wird gemäß der vorliegenden Erfindung ein Verfahren zur Herstellung eines mit Metall oder einer Legierung befüllten Substrats auf Basis von makroporösem Silizium, das als Träger für mikroelektronische Bauteile, insbesondere Chips, geeignet ist, bereitgestellt, umfassend die Schritte:
(i) Erzeugen von Sacklöchern mit einer Tiefe im Bereich von 25 bis 1000 µm, vorzugsweise 100 bis 250 µm, und einem Durchmesser im Bereich von 5 bis 150 µm, vorzugsweise 5 bis 30 µm, von der ersten, vorderseitigen Oberfläche eines Siliziumsubstrats aus,
(ii) Erzeugen einer Isolatorschicht auf den Oberflächen des in Schritt (i) erhaltenen Substrats,
(iii) selektives isotropes Ätzen von der zweiten, rückseitigen Oberfläche aus unter Freilegen der in Schritt (ii) erzeugten Sacklöcherenden derart, dass die jeweiligen Sacklöcherwände, welche durch die in Schritt (ii) erzeugte Isolatorschicht gebildet werden, auf der rückseitigen Oberfläche aus dem Substrat herausragen und in diesem Bereich nur durch die, die jeweilige Sacklochwand bildende Isolatorschicht definiert werden, was wiederum über die Länge der herausragenden Isolatorschicht eingestellt werden kann,
(iv) Erzeugen einer weiteren Isolatorschicht auf den Oberflächen des in Schritt (iii) erhaltenen Substrats,
(v) Befüllen mindestens einer Vielzahl, d.h. mindestens 50 bis 100 %, der erzeugten Sacklöcher mit Metall durch Einbringen des in Schritt (iii) bzw. (iv) erhaltenen Substrats in eine Schmelze davon unter Druck in einer die Schmelze enthaltenden Prozesskammer,
(vi) asymmetrisches Abkühlen der Schmelze in den Sacklöchern von der vorderseitigen Oberfläche aus, so dass eine Kontraktion des Metalls beim Abkühlen in den Sacklöchern zur rückseitigen Oberfläche hin erfolgt, bis die erstarrte Metalloberfläche auf einer Ebene mit der rückseitigen Oberfläche des Substrats liegt, und
(vii) Entfernen der übrigen unbefüllten, aus dem Substrat herausragenden und in diesem Bereich nur durch die Isolatorschicht gebildeten Sacklöcherenden.

Gegebenenfalls kann nach Schritt(iii) bzw. vor Schritt (iv) ein mechanisches oder chemisches Entfernen der aus dem Substrat herausragenden Isolatorschicht in den Bereichen, in denen die Poren nicht mit Metall gefüllt sein sollen, vorgesehen werden, um die Metalllagen auf beiden Oberflächen des Substrats gegeneinander zu isolieren.

Ein weiterer Gegenstand der vorliegenden Erfindung betrifft ein mit Metall oder einer Legierung befülltes Substrat auf Basis von makroporösem Silizium, das als Träger für mikroelektronische Bauteile, insbesondere Chips, geeignet ist, wobei das Substrat gegenüberliegend eine erste und zweite Oberfläche aufweist, wobei über den gesamten Oberflächenbereich verteilt eine Vielzahl von diskreten Durchgangslöchern mit einem Durchmesser im Bereich von 5 bis 150 µm angeordnet ist, wobei die Oberflächen und die Innenwände der Durchgangslöcher des Substrats von einer Isolatorschicht bedeckt sind, und wobei die Durchgangslöcher vollständig mit Metall oder einer Metalllegierung befüllt sind, so daß die metallgefüllten Durchgangslöcher als Vias die Metallisierungsebenen der ersten und zweiten Oberfläche elektrisch miteinander kontaktieren, wobei sowohl die Kontakte jeweils voneinander elektrisch isoliert sind als auch jeder Kontakt elektrisch gegen das Substrat isoliert ist.

In einer bevorzugten Ausführungsform ist das Metall zur Befüllung der Durchgangslöcher aus Aluminium oder einer Legierung davon mit Silizium oder Kupfer ausgewählt. Die Isolatorschicht ist vorzugsweise auf Basis von SiO₂ oder Si₃N₄.

Die Dicke eines solchen erfindungsgemäßen Substrats beträgt üblicherweise zwischen 25 bis 1000 µm, vorzugsweise 100 bis 250 µm. Die Dichte der befüllten Durchgangslöcher liegt vorzugsweise im Bereich von 10⁴ bis 10⁶/cm². Üblicherweise kann mit dem erfindungsgemäßen Verfahren ein Aspektverhältnis im Bereich von 1:5 bis 1:50 realisiert werden.

Das erfindungsgemäße Substrat stellt einen universell einsetzbaren Chip-Träger für die Montage mehrerer mikroelektronischer Bauteile (d.h. Dies, bevorzugt aus Silizium) dar, welcher diese Bauteile sehr gut elektrisch leitend und wärmeleitend miteinander verbindet, sehr gute Zuverlässigkeitseigenschaften aufweist, bis zu 450°C temperaturbeständig ist und kostengünstig hergestellt werden kann.

Das der vorliegenden Erfindung zugrundeliegende Konzept zeichnet sich zudem durch folgende Vorteile aus:
- hohe Zuverlässigkeit der Isolatorschicht, da der Isolator auf allen Oberflächen bei der erfindungsgemäßen Prozessführung bereits vor der Metallisierung abgeschieden werden kann und nicht mehr entfernt werden muss. Dadurch ist es beispielsweise möglich, durch thermische Oxidation erzeugtes SiO₂ zu verwenden, das im Vergleich zu SiO₂, das mittels eines CVD-Prozesses erzeugt wurde, eine höhere Zuverlässigkeit und bessere dielektrische Eigenschaften aufweist;
- die Kernprozesse Porenätzen und Metallisierung der Sacklöcher bzw. Poren sind extrem kostengünstig realisierbar;
- kurze Prozeßkette durch geschickte Prozeßführung;
- innovative, schnelle Metallisierung der Sacklöcher bzw. Poren;
- Einsatz bekannter Standard-Materialien, dadurch hohe Zuverlässigkeit;
- kompatibel mit Standard-Verfahren und Anlagen der Halbleiterindustrie;
- gute elektrische Leitfähigkeit der Durchkontaktierungen, insbesondere wenn Aluminium als Metall zur Füllung der Durchgangslöcher verwendet wird; und
- hohe Temperaturbeständigkeit des fertigen Trägers günstig für nachfolgende "bond"- und "cut"-Prozesse.

Die prinzipielle Verwendung von Silizium als Trägermaterial hat folgende Vorteile:
- exzellente Wärmeleitfähigkeit des Substrates
- hohe Integrationsdichte für high density packaging, da "Backend of Line" Prozesse benutzt werden können
- angepasster Ausdehnungskoeffizient zwischen Chip und Chipträger.

Das Problem der Verdrahtung von einzelnen mikroelektronischen Bauteilen bzw. Silizium-Chips wird durch das erfindungsgemäße, lokal beidseitig metallisierte Siliziumsubstrat gelöst, worin beide Metallebenen, d.h. diejenigen auf der ersten vorderseitigen und der zweiten rückseitigen Oberfläche, dabei durch metallgefüllte Durchgangslöcher, die als Vias fungieren, elektrisch gut leitend miteinander verbunden sind.

Der Vorteil des erfindungsgemäßen Verfahrens bzw. des dadurch erhältlichen Substrats besteht einerseits darin, daß die thermische Leitfähigkeit von Silizium (~ 148 W/m K) viel größer als die herkömmlicher Leiterplatten ist. Die Wärmeleitung des gesamten Aufbaus aus mehreren Silizium-Chips, die über definierte Kontakte und Leiterbahnen elektrisch leitend durch den erfindungsgemäßen Chip-Träger verbunden werden können, ist daher wesentlich verbessert. Die Wärmeabfuhr kann auf diese Weise deutlich gesteigert werden und es treten weniger Probleme durch Überhitzung der mikroelektronischen Bauelemente auf (z.B. Zuverlässigkeitsprobleme durch Elektromigration).

Durch Verwendung eines Chip-Trägers aus Silizium, wie erfindungsgemäß vorgesehen, erreicht man darüber hinaus eine Anpassung der thermischen Ausdehnungskoeffizienten des gesamten Aufbaus. Da sowohl der Träger als auch die mikroelektronischen Chips dann aus demselben Material bestehen und die gute Wärmeleitung entsprechende Temperaturgradienten stark reduziert, gibt es weder bei konstanter Temperatur noch bei Temperaturveränderungen nennenswerte mechanische Spannungen im Aufbau.

Bei Verwendung von insbesondere Aluminium als Material für die Durchkontaktierung des erfindungsgemäßen Substrats bzw. Chip-Trägers wird nicht nur eine sehr gute elektrische Leitfähigkeit erreicht, sondern zusätzlich die Möglichkeit eröffnet, die Oberflächen des Chip-Trägers mit herkömmlichen Prozessen wie Sputtern oder CVD-Verfahren bei Temperaturen von bis zu ca. 450°C mit dünnen Metallfilmen oder Isolatoren zu beschichten und auf diese Weise Leiterbahnen herzustellen bzw. darauf zu erzeugen.

Durch das erfindungsgemäße Herstellungsverfahren ist außerdem eine im Vergleich zu herkömmlichen Methoden der Halbleiterindustrie sehr viel kostengünstigere Herstellung möglich.

Die Figuren zeigen:
Fig. 1 zeigt schematisch die wesentlichen Verfahrensschritte zur Herstellung einer bevorzugten Ausführungsform des erfindungsgemäßen Substrats.
Fig. 2 zeigt das erfindungsgemäße Substrat mit darauf photolithographisch angeordneten Leiterbahnen.
Fig. 3 zeigt ein Anwendungsbeispiel des erfindungsgemäßen Chipträgers in Verbindung mit üblichen Standard-Flip-Chip-Interconnects und einem Face-to-Face Interconnect.

Im folgenden wird das erfindungsgemäße Herstellungsverfahren näher erläutert.

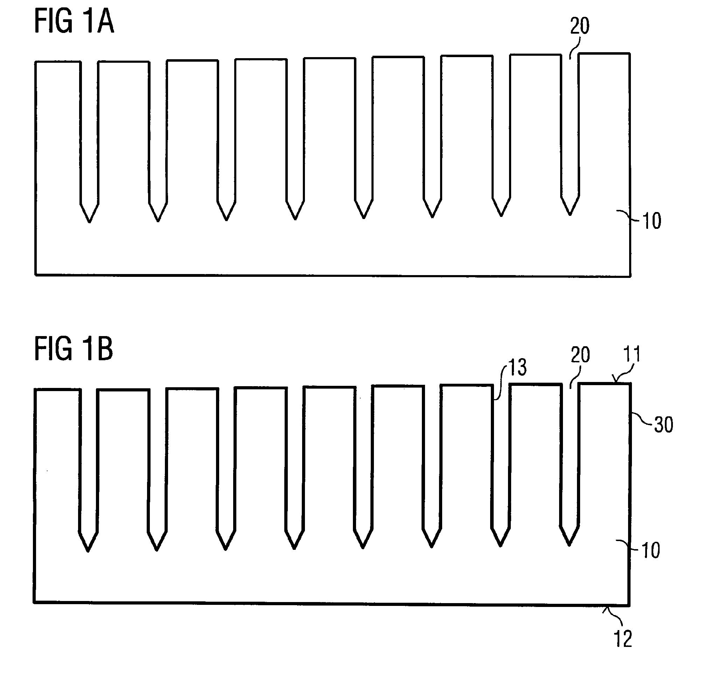

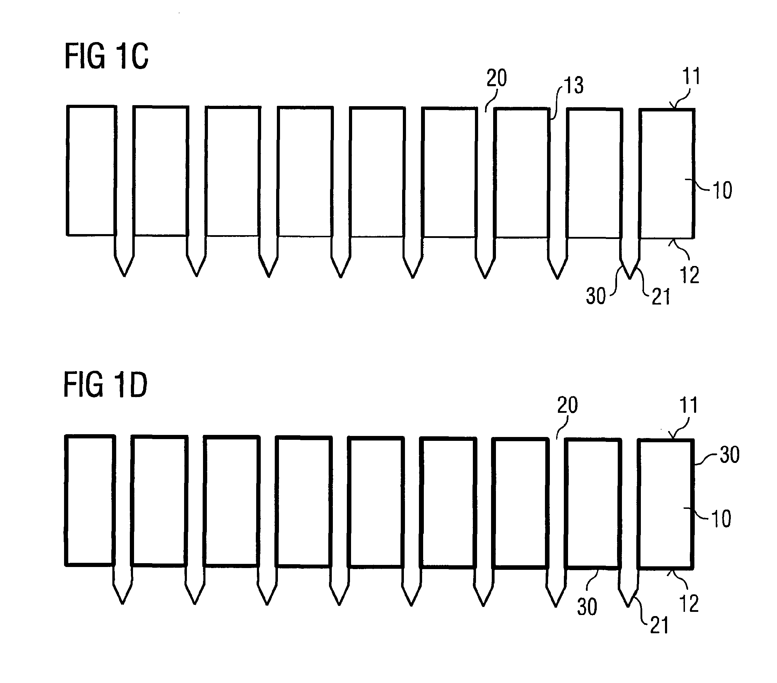

Zur Herstellung des erfindungsgemäßen Chip-Trägers wird bevorzugt niedrig n- oder p-dotiertes (- 1000 Ohm cm) Silizium verwendet. Die parasitäre Kapazität des Substrates ist dadurch besonders gering. Die Herstellung der Vias bzw. Kontaktlöcher, die nachfolgend die eine metallisierte Seite des TrägerSubstrates mit der anderen metallisierten Seite des Substrates verbinden, erfolgt bevorzugt durch elektrochemisches Ätzen, wie es z.B. in EP-A1-0 296 348 oder in V. Lehmann, J. Elektrochem. Soc. 140, 1993, Seiten 2836 ff., beschrieben ist. Alternativ lassen sich die Poren auch durch andere in der Mikromechanik bekannte Ätzverfahren, wie reaktives Ionenätzen (RIE) oder Laserbohren, herstellen. Die so erzeugten Sacklöcher bzw. Poren im Substratmaterial weisen eine Tiefe im Bereich von 25 bis 1000 µm, vorzugsweise 100 bis 250 µm, auf. Der Durchmesser der Poren liegt dabei im Bereich von 5 bis 150 µm, vorzugsweise zwischen 5 und 30 µm. Figur 1A zeigt das Substrat (10) aus Silizium mit den entsprechenden Sacklöchern (20) nach Durchführung des Schritts (i) gemäß dem Verfahren der vorliegenden Erfindung.

Auf die Oberflächen des auf diese Weise vorbereiteten Substrates wird anschließend gemäß Schritt (ii) eine Isolatorschicht (30) aufgebracht, vorzugsweise ein durch thermische Oxidation erzeugtes Siliziumdioxid. Es können aber auch andere Verfahren und Isolatormaterialien verwendet werden, z.B. mittels eines Chemical-Vapour-Deposition-Verfahrens (CVD) aus TEOS (Tetra-Ethyl-Ortho-Silicat) erzeugtes oder gesputtertes SiO₂ oder aus Silan (SiH₄) und Ammoniak (NH₃) erzeugtes Siliziumnitrid. Die Dicke der Isolatorschicht liegt vorzugsweise im Bereich von 10 bis 2000 nm, mehr bevorzugt zwischen 100 und 500 nm. Die Isolatorschicht (30) bedeckt dabei alle Oberflächen des Substrates, d.h. die erste Oberfläche (Vorderseite) (11) und die zweite Oberfläche (Rückseite) (12) sowie die Innenseite der Sacklöcher bzw. Poren (13). Figur 1B zeigt das Substrat 10 nach Durchführung des Schritts (ii) gemäß dem Verfahren der vorliegenden Erfindung.

Nach dem Erzeugen der Isolatorschicht werden die von der ersten, vorderseitigen Oberfläche (11) aus erzeugten Sacklöcher (20) durch selektives isotropes Ätzen von der zweiten rückseitigen Oberfläche (12) aus freigelegt und zwar derart, daß die Isolatorschicht (30) in den Sacklöchern und insbesondere an den Sacklöcherenden erhalten bleibt und nur das Silizium entfernt wird (vgl. Fig. 1C). Dazu wird die Isolatorschicht (30) von der zweiten rückseitigen Oberfläche (12) durch naß- oder trockenchemisches Ätzen entfernt, und anschließend das Silizium einseitig, z.B. naßchemisch mit KOH oder TMAH, geätzt. Alternativ kann ein erster Teil des Siliziums auch durch mechanisches Schleifen oder Läppen entfernt werden, und anschließend ein naß- oder trockenchemisches Verfahren eingesetzt werden, um die Isolatorschicht in den Sacklöchern zerstörungsfrei freizulegen. Figur 1C zeigt das Substrat 10 mit den bereichsweise freigelegten Sacklöcherenden (21) nach Durchführung des Schritts (iii) gemäß dem Verfahren der vorliegenden Erfindung. In dem Bereich, in dem die Sacklöcher freigelegt sind, sind diese nur durch die beim Rückätzen des Siliziums nicht entfernte Isolatorschicht definiert. Auch bei Schichtdicken des Isolators von 200 nm und darunter gelingt es, das Silizium über die gesamte Fläche des Wafers kontrolliert zu entfernen, ohne die Isolatorschicht zu beschädigen. Die Höhe des freigelegten Teils der Sacklöcher entspricht typischerweise zwischen 5 and 30% der verbleibenden Waferdicke. Bei einer Restwaferdicke von 250 µm beträgt die Höhe des über das Substrat hinausragenden und durch die Isolatorschicht definierten Bereiches der Sacklöcher z.B. zwischen 10 und 50 µm, vorzugsweise etwa 30 µm. Überraschenderweise sind die durch die Isolatorschicht definierten Bereiche der Sacklöcher trotz des großen Verhältnisses von Höhe (z.B. 30 µm) zu der Schichtdicke des Isolators (z.B. 200 nm) mechanisch sehr stabil and defektfrei.

Anschließend werden alle Oberflächen des Substrates mit einer weiteren Isolatorschicht (30) versehen, insbesondere die zweite rückseitige Oberfläche (12), auf der die Isolatorschicht entfernt wurde. Vorzugsweise erfolgt dieser Prozeßschritt durch thermische Oxidation des Siliziums. Es können aber auch andere Verfahren und Isolatormaterialien oder Kombinationen von Verfahren und Materialien verwendet werden, z.B. mittels eines Chemical-Vapour-Deposition-Verfahrens (CVD) aus TEOS (Tetra-Ethyl-Ortho-Silicat) erzeugtes oder gesputtertes SiO₂ oder aus Silan (SiH₄) und Ammoniak (NH₃) erzeugtes Siliziumnitrid. Die Dicke der Isolatorschicht liegt vorzugsweise im Bereich von 10 bis 1000 nm, mehr bevorzugt zwischen 100 und 500 nm. Der Isolator bedeckt dabei alle Oberflächen des Substrates, die erste (11) und die zweite Oberfläche (12) sowie die Innenseite der Sacklöcher bzw. Poren (21) (vgl. Fig. 1D). In Teilbereichen des Substrates kommt es durch diese zweite Isolatorschicht zu einer Erhöhung des Gesamtdicke des Isolators, nämlich dort, wo die erste Isolatorschicht nicht entfernt wurde. An diesen Stellen wächst die zuvor aufgebrachte Isolatorschicht, z.B. SiO₂, weiter. Figur 1D zeigt das Substrat 10 mit den bereichsweise freigelegten Sacklöchern (21) nach Durchführung des Schritts (iv) gemäß dem Verfahren der vorliegenden Erfindung.

Durch diese Art der Prozeßführung entstehen Sacklöcher bzw. Poren, die auf der Seite der zweiten Oberfläche (12) aus dem Siliziumsubstrat herausragen und in diesem Bereich nur durch die Isolatorschicht (30) definiert sind. Diese Art von geschlossenen Poren stellt Sacklöcher dar, die geeignet sind, um sie in einer Schmelze unter Druck mit einem flüssigen Metall oder einer Legierung aus zwei oder mehreren Metallen (40) oder Halbleitern, wie z.B. AlSiCu, zu füllen, wie in V. Lehmann, Sensors and Actuators A95, 2002, Seiten 202 ff. beschrieben.

Es wird angemerkt, daß beidseitig offene Poren, deren Innenfläche für die Metallschmelze nicht benetzend ist, auf Grund der Kapillarkräfte sich nicht mit flüssigem Metall füllen lassen. Dieser Effekt kann vorteilhaft in dem erfindungsgemäßen Verfahren ausgenutzt werden. Indem der überstehende, nur durch den Isolator definierte Teil der Poren lokal entfernt wird, z.B. durch photolithographische Strukturierung und anschließendes Ätzen oder mittels eines Lasers oder durch mechanische Einwirkung (Kratzen, Ritzen, Sägen bzw. Schleifen), können Bereiche definiert werden, in denen die Poren nicht mit Metall gefüllt werden. Diese Bereiche, in denen auf Grund der nicht mit Metall gefüllten Poren keine elektrisch leitende Verbindung zwischen beiden Oberflächen des Substrats entsteht, können insbesondere dazu benutzt werden, die erste Metallebene auf der ersten Oberfläche des Substrats von der ersten Metallebene auf der zweiten Oberfläche zu isolieren. Werden nämlich alle homogen über das Substrat verteilten Poren mit Metall gefüllt, so müssen die metallisierten Kontaktlöcher in den Bereichen, in den keine elektrisch leitende Verbindung von der Vorder- zur Rückseite des Substrats entstehen soll (z.B. an Stellen, an denen sich die Leiterbahnen auf der Vorder- und der Rückseite kreuzen), auf mindestens einer Oberfläche mit einer Isolatorschicht überdeckt werden, um Kurzschlüsse zu verhindern.

Diese metallfreien Bereiche ermöglichen außerdem das Vereinzeln eines großen Substrates oder Wafers zu einzelnen Chips durch herkommliches Sägen, z.B. mit einem Diamant-Sägeblatt. Wenn die Poren in dem Substrat-Bereich, der durch das Sägeblatt entfernt wird, nämlich mit Metall gefüllt wären, würde das zu einem Verschmieren des Metalls auf dem Sägeblatt führen. Das Sägeblatt würde dadurch seine normale Funktion verlieren bzw. Sägeblatt und Substrat würden mit hoher Wahrscheinlichkeit zerstört. Auch im Hinblick auf die elektrischen und magnetischen Eigenschaften des Chip-Trägersubstrates kann es von Vorteil sein, Bereiche zu definieren, in denen einerseits die Poren nicht mit Metall gefüllt sind, andererseits das Substratmaterial aber durch Ätzung der Poren entfernt wurde. Dadurch wird z.B. die mittlere Dielektrizitatskonstante des Substrates reduziert, wodurch parasitäre Kapazitäten zwischen Leiterbahnen und Substrat verringert werden können.

Zur Befüllung der Sacklöcher (20) wird das Substrat (10) in eine gasdichte Prozeßkammer eingeführt, welche die Schmelze enthält. Während die Kammer evakuiert wird, befindet sich das Substrat über der Oberfläche der Schmelze. Nachdem der gewünschte Druck im Bereich von üblicherweise 1 bis 100 mbar, vorzugsweise im Bereich von 10 bis 50 mbar erreicht ist, wird das Substrat in die Schmelze getaucht und die Prozeßkammer mit Druck beaufschlagt. Der Druck liegt vorzugsweise im Bereich von 1 bis 20 bar, mehr bevorzugt im Bereich von 5 bis 10 bar. Der erforderliche Druck hängt dabei von der Prozeßtemperatur, der Oberflächenspannung des verwendeten Metalls bzw. der verwendeten Legierung und dem Durchmesser der Poren ab. Durch Beaufschlagen der Prozesskammer mit hohem Druck wird die flüssige Metallschmelze in die vorher evakuierten Sacklöcher gedrückt. Überraschenderweise halten die auf der Rückseite des Substrates nur durch die Isolatorschicht definierten Bereiche der Poren dieser Art der Prozessführung ohne weiteres Stand. Während das Substrat aus der Metallschmelze gezogen wird, bleibt der hohe Druck in der Prozesskammer erhalten.

In einer bevorzugten Ausführungsform ist die Schmelze aus (übereutektischem) Aluminium, das z.B. auch mit Silizium und/oder Kupfer legiert sein kann. Dadurch wird eine niedrige Schmelztemperatur von weniger als 600°C, eine gute Leitfähigkeit der gefüllten Poren bzw. Sacklöcher und eine gute chemische Verträglichkeit zwischen Siliziumdioxid, Siliziumnitrid und Silizium erreicht.

In einer weiteren bevorzugten Ausführungsform wird hochreiner trockener Stickstoff oder ein hochreines trockenes Edelgas wie Argon als Prozessgas in der Prozesskammer zum Erzeugen des Druckes beim Füllen mit flüssigem Metall verwendet. Dadurch kann verhindert werden, dass die Oberfläche des flüssigen Metalls eine Oxidschicht bzw. Schlacke ausbildet, die das Füllen kleiner Poren erschwert und die Ausbeute verringert. In die Prozeßkammer kann außerdem eine mechanische Vorrichtung eingebaut sein, die es erlaubt, die Oberfläche der Metallschmelze zu reinigen, indem ein temperaturbeständiger Schaber aus Metall oder Keramik etwas in die Schmelze eingetaucht und von einer Seite des Schmelztiegels zur anderen Seite über die gesamte Oberfläche der Schmelze geschoben oder gezogen wird.

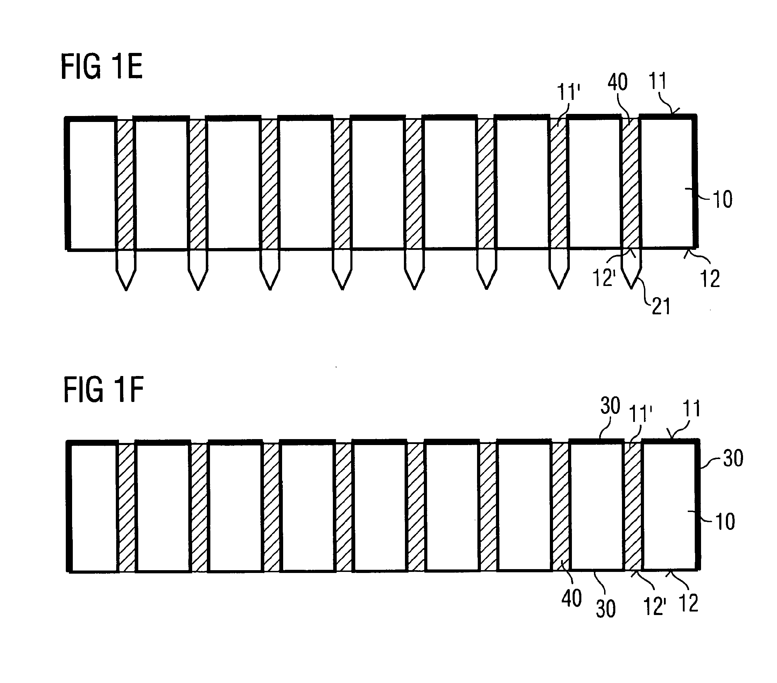

Bei asymmetrischem Abkühlen der Schmelze in den Poren bzw. Sacklöchern von der Seite der ersten Oberfläche (11) aus erstarrt die Schmelze zunächst an der ersten Oberfläche. Die erste Substratoberfläche (11) liegt dabei auf einer Ebene mit der ersten Oberfläche des erstarrten Metalls (11') in den Poren bzw. Sacklöchern (vgl. Fig. 1E). Die Prozesskammer ist üblicherweise derart gestaltet, dass die Erstarrung des Metalls in den Poren kontrolliert werden kann. Nachdem das Substrat aus der Schmelze gezogen worden ist, kann die Abkühlung der ersten Oberfläche (Seite der Porenöffnung) z.B. durch eine der Oberfläche gegenüberliegende wassergekühlte Metallplatte beschleunigt werden. Die Abkühlung der Schmelze von der Rückseite des Substrates her wird z.B. durch eine Lampenheizung oder eine beheizte Metalloberfläche verhindert bzw. verlangsamt. Dadurch kann erreicht werden, dass die Erstarrung des Metalls in den Poren von der Vorderseite zur Rückseite hin erfolgt. Im weiteren Verlauf des Abkühlens wird das Material in das Sackloch hineingezogen, so daß eine Kontraktion des Materials (40) beim Abkühlen in den Poren zur Seite der ersten Oberfläche (11) hin erfolgt. Der Prozeß wird üblicherweise derart geführt, daß sich das Material (40) so weit zusammenzieht, daß die erstarrte Oberfläche (12') auf einer Ebene mit der zweiten Oberfläche (12) des Substrates (10) liegt. Das kann erreicht werden, indem die Länge des überstehenden und nur durch die Isolatorschicht definierten Teils der Poren so eingestellt wird, dass das Volumen dieses Teils etwa der Volumendifferenz zwischen dem Volumen der flüssigen Schmelze und dem Volumen des erstarrten Metalls bei Raumtemperatur entspricht. Im flüssigen Zustand füllt also das Metall die gesamte Pore einschließlich des Bereiches der Pore, der nur durch die Isolatorschicht definiert ist. Durch Kontraktion des Metalls beim asymmetrischen Abkühlen im Bereich des Substrates wird nach und nach das Metall aus dem Bereich der nur durch die Isolatorschicht definierten Pore in den Bereich des Substrates gezogen. Zur Einstellung des Metallvolumens und damit der Höhe der erstarrten Metalloberfläche kann auch der Druck verwendet werden. Je nachdem, bis zu welchem Druck die Kammer vor dem Füllprozess evakuiert wird und wie groß der Druck in der Prozesskammer beim Füllen der Poren ist, füllt das flüssige Metall die gesamte Pore oder nur einen Teil davon. Erst nach dem Erstarren wird der Druck auf Normaldruck reduziert. Figur 1E zeigt das Substrat 10 nach Durchführung des Schritts (vi) gemäß dem Verfahren der vorliegenden Erfindung

Diese Art der Metallfüllung von Poren bzw. Sacklöchern erlaubt einen wesentlich höheren Durchsatz pro Zeiteinheit und wesentlich geringere Prozeßkosten als herkömmliche Arten der Metallfüllung aus der Gasphase (CVD) oder elektrochemisches oder chemisches Plating. CVD-Verfahren sind wegen des üblicherweise angestrebten großen Aspektverhältnisses und der geringen Abscheideraten nur bedingt einsetzbar. Einerseits ist eine homogene Abscheidung am Boden der Sacklöcher nach dem Stand der Technik im Produktionsmaßstab nicht möglich, andererseits sind die erreichbaren Abscheideraten so gering, dass zur Füllung der Sacklöcher extrem lange Prozesszeiten, die mit hohen Kosten verbunden sind, erforderlich wären. Werden Poren mit einem Durchmesser von beispielsweise mehr als 50 µm zur Herstellung der Vias verwendet, so kann die Füllung der Poren mit Metall gegebenenfalls auch mittels eines elektrochemischen Abscheideverfahrens (ECD = Electrochemical Deposition) erfolgen. Die dazu erforderliche leitfähige Bekeimungsschicht auf der Isolatorschicht kann in diesem Fall mittels Sputtern (PVD = Physical Vapour Deposition) und/oder CVD-Verfahren (Chemical Vapour Deposition) hergestellt werden. Sputterverfahren sind für die Füllung von Poren bzw. Sacklöchern mit den erfindungsgemäß angestrebten Aspektverhältnissen und Dimensionen nicht geeignet. Bei großen Aspektverhältnissen (große Tiefe, geringer Durchmesser) ist es nicht möglich, gesputtertes Material derart in das Sackloch abzuscheiden, dass das Loch homogen mit Material gefüllt wird. Außerdem liegen die mit Sputterverfahren bei wirtschaftlich sinnvollen Prozesszeiten herstellbaren Schichtdicken typischerweise im Bereich von wenigen hundert Nanometern. Die erfindungsgemäß angestrebten Poren haben dagegen vorzugsweise eine Tiefe im Bereich von 100 bis 250 µm und einen Durchmesser von vorzugsweise 5 bis 30 µm.

Im nächsten Prozeßschritt (vii) wird der freiliegende Teil der Isolatorschicht (30), der das Porenende bzw. Sacklochende der freigelegten Sacklöcher (21) definierte, durch eine naß- oder trockenchemische Ätzung, durch mechanisches Schleifen oder durch Ultraschall entfernt. Figur 1F zeigt das Substrat 10 nach Entfernung der bereichsweise freigelegten Sacklöcherenden (21) nach Durchführung des Schritts (vii) gemäß dem Verfahren der vorliegenden Erfindung. Aus den zuvor erzeugten Sacklöchern (20) werden durch diesen Schritt Durchgangslöcher (22) erzeugt, die mit Metall oder einer Metalllegierung (40) befüllt sind.

Gemäß dem Verfahren der vorliegenden Erfindung wird ein gut wärmeleitendes Substrat mit Kontakten, welche die erste Oberfläche (11) elektrisch gut leitend mit der zweiten Oberfläche (12) verbinden, wobei sowohl jeder Kontakt gegen jeden weiteren Kontakt elektrisch isoliert ist, als auch jeder Kontakt elektrisch gut gegen das Substrat isoliert ist, erhalten. Aufgrund der Isolatordicke ist die parasitäre Kapazität des Substrates selbst gering. Insbesondere bietet die Art der hier vorgestellten Prozeßführung, sotern auch die thermische Oxidation als Prozeß zum Aufbringen der zweiten Isolatorschicht angewendet wird, den Vorteil, daß alle Substratoberflächen zuverlässig isoliert werden und so eine sehr hohe Ausbeute bei der Herstellung des erfindungsgemäßen Substrates erreicht werden kann.

Ein weiterer großer Vorteil der beschriebenen Prozessführung besteht darin, dass die Füllung der Poren mit Metall bei sehr hohen Temperaturen zwischen 400 und 700°C erfolgen kann. Bei der Abkühlung und Kontraktion des Metalls in den Poren entstehen kleine Hohlräume zwischen dem Isolator und dem Metall entlang der mit Metall gefüllten Poren. Da der fertige Chip-Träger im Produkt großen Temperaturschwankungen standhalten muss und sich das Metall in den Poren bei der Erwärmung im Betrieb wieder ausdehnt, erweisen sich diese Hohlräume als sehr vorteilhaft, indem sie dem Metall freies Volumen zur Expansion zur Verfügung stellen. Ohne dieses Expansionsvolumen würde sich das Metall bei Erwärmung sehr stark entlang der Längsachse des Vias über die erste und zweite Oberfläche des Substrates hinaus ausdehnen und dadurch die auf der Ober- und Unterseite des Substrates befindlichen Schichten anheben und beschädigen, was zur Zerstörung des Chip-Trägersubstrates führen würde.

Das erfindungsgemäß prozessierte Substrat bietet den Vorteil, daß es aufgrund der verwendeten Materialien und bei Verwendung von Standard-Substrat-Formaten (Wafer) mit herkömmlichen Prozessen und Anlagen der Halbleiterindustrie weiterverarbeitet werden kann. Insbesondere können aufgrund der Temperaturbeständigkeit des Substrates und der Metallfüllung auf einer oder auf beiden Oberflächen des Substrates eine oder mehrere Metallschichten in Dünnfilmtechnik durch z.B. Sputtern oder CVD-Verfahren oder auch durch elektrochemische Abscheidung aufgebracht und photolithographisch strukturiert werden.

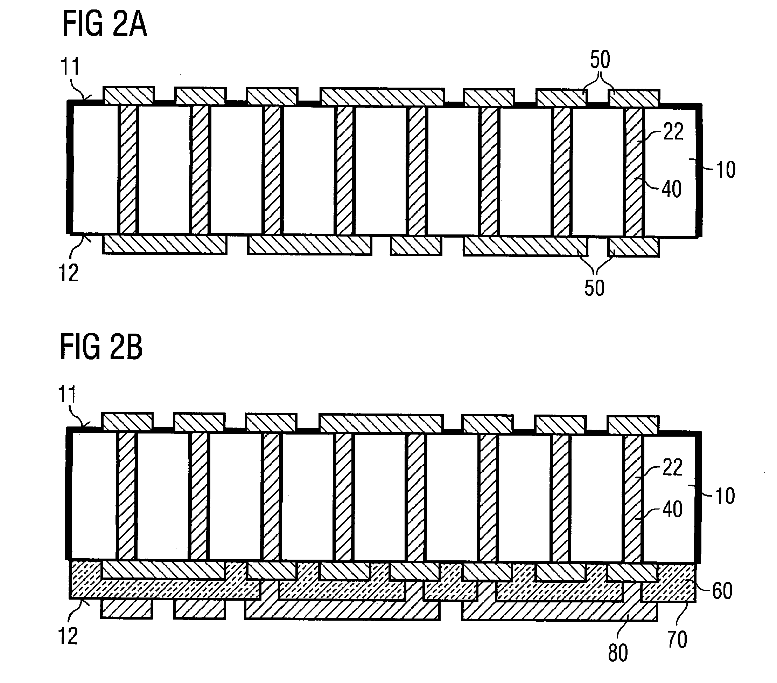

Dadurch können Leiterbahnen (Redistribution Layers) erzeugt werden, um Spannungen und Ströme auf der Oberfläche an beliebigen Positionen zur Verfügung zu stellen (vgl. Fig. 2A und 2B). Fig. 2A zeigt das erfindungsgemäße Substrat mit auf beiden Oberflächenseiten (11, 12) photolithographisch angeordneten Leiterbahnen (50). Eine vorbestimmte Anzahl der Leiterbahnen (50) kann mittels zumindest einer Metallfüllung (40) leitend verbunden werden. Es ist daher erfindungsgemäß möglich, Leiterbahnen (50), welche sich an gegenüberliegenden Oberflächen (11, 12) des Substrats (10) befinden, leitend miteinander zu verbinden. Folglich können Spannungen und Ströme nicht lediglich an einer Oberfläche (11, 12) zur Verfügung gestellt werden. Vielmehr ist es möglich, beispielsweise einen Strom von der ersten Oberfläche (11) auf die zweite Oberfläche (12) zu leiten und/oder von der zweiten Oberfläche (12) auf die erste Oberfläche (11). Insbesondere können daher auch oberflächenübergreifende leitfähige Verbindungen erzeugt werden und beispielsweise elektronische Bauteile, welche an verschiedenen Oberflächen (11, 12) des Substrats (10) angeordnet sind, leitend miteinander verbunden werden.

Fig. 2B zeigt eine bevorzugte Ausführungsform des erfindungsgemäßen Substrats (10), wie es auch in Figur 2A dargestellt ist, wobei die elektrischen Leiterbahnen 50 zumindest an einer der ersten und zweiten Oberfläche (11, 12) mit einem Isolator (60) zumindest bereichsweise bedeckt ist. An einer freien Fläche (70), insbesondere einer freien Oberfläche (70) des Isolators (60) ist zumindest eine weitere elektrische Leiterbahn (80), vorzugsweise aus einem elektrisch gut leitfähigen Material, beispielsweise Aluminium oder Kupfer, angeordnet. Die elektrische Leiterbahn (80) ist vorzugsweise aus dem gleichen Metall hergestellt, mit welchem auch das Durchgangsloch (22) gefüllt ist bzw. aus welchem die Leiterbahn (50) besteht.

Die elektrische Leiterbahn (80) kann mit einer oder mehreren der Leiterbahnen (50), welche an der zweiten Oberfläche (12) des Substrats angeordnet sind, durch den Isolator (60) hindurch elektrisch leitend verbunden sein. Die elektrische Leiterbahn (80) wiederum kann beispielsweise mit weiteren elektrischen Leiterbahnen und/oder einem oder mehreren elektrischen bzw. elektronischen Bauteilen verbunden sein. Folglich kann in einfacher Weise eine Vielzahl von elektrisch leitfähigen Verbindungen bereitgestellt werden.

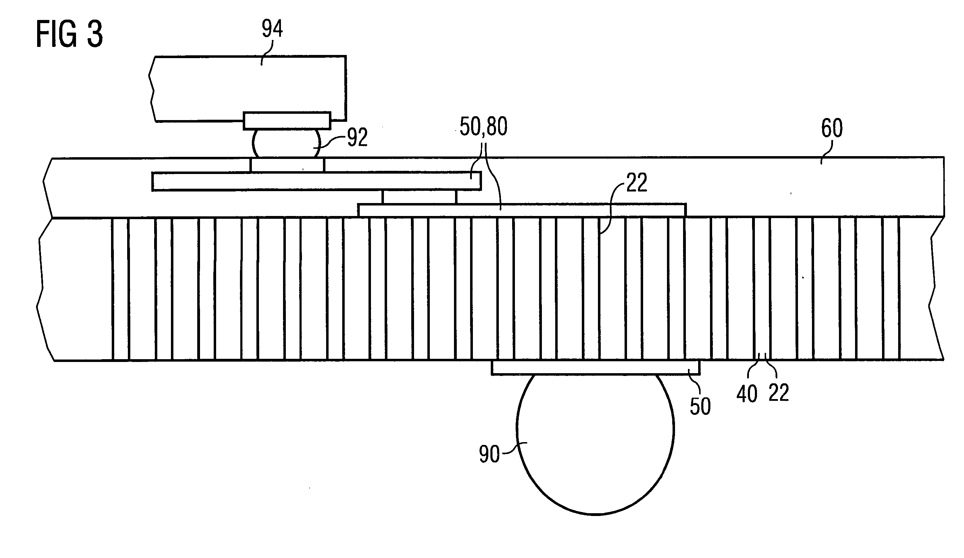

Fig. 3 zeigt ein Anwendungsbeispiel des erfindungsgemäßen Chipträgers in Verbindung mit bekannten Standard-Flip-Chip-Interconnects (90) als bevorzugtes elektronisches Bauteil, welches beispielhaft an der ersten Oberfläche (11) angeordnet ist und einem Face-to-Face Interconnect (92), als weiteres bevorzugtes elektronisches Bauteil, welches an der zweiten Oberfläche (12) des Substrats 10 angeordnet ist. Das Face-to-Face Interconnect (92) ist mittels der Leiterbahnen (50, 80) durch das Substrat (10) hindurch mit dem Standard-Flip-Chip-Interconnect (90) elektrisch leitend verbunden, wobei die elektrische Verbindung durch das Substrat (10) hindurch mittels der Durchgangslöcher (22) und des darin angeordneten Metalls (40) sowie der an den Oberflächen (11, 12) des Substrats (10) angeordneten Leiterbahnen (50, 80) hergestellt wird.

Ferner ist in Figur 3 ein photolithographisch strukturierbares Polyimid (60) als bevorzugter Isolator dargestellt, welches die metallische Leiterbahn (50) von der metallischen Leiterbahn (80) beabstandet bzw. trennt, wobei elektrischer Kontakt der Leiterbahn (50) mit der Leiterbahn (80) durch das Polyimid (60) hindurch möglich ist.

Ferner zeigt Figur 3 einen Chip (94) auf Halbleiterbasis (Silicon IC Die), welcher mit dem Face-to-Face Interconnect (92) elektrisch leitend verbunden ist. Der Chip (94) ist folglich mit dem Standard-Flip-Chip Interconnect (90) elektrisch leitend verbunden, wodurch in einfacher Weise eine Kommunikation zwischen dem Chip (94) und dem Standard-Flip-Chip Interconnect (90) ermöglicht wird.

Ein weiterer Vorteil der durch die vorliegende Erfindung realisierbaren Parallelschaltung von kleinen Kontaktlöchern, wie eingangs erwähnt, besteht darin, dass eine Kosteneinsparung in dem Sinne möglich ist, dass ein universelles Substrat mit Vias hergestellt werden kann, das nicht produktspezifisch angepasst sein muss. Dazu werden die Vias vollständig homogen auf dem Wafer verteilt, d.h. der Abstand der Vias ist in x- and y-Richtung über den gesamten Wafer konstant and beträgt z.B. in beide Richtungen jeweils 10 µm. Es werden also auch in dem Bereich Vias erzeugt, in dem sie nicht benötigt werden. Das produktspezifische Design entsteht erst durch die photolithographische Definition der Leiterbahnen auf der Ober- und Unterseite des Substrates. Auf die Justierung der Kontaktflächen zwischen Via und Leiterbahn auf der Ober- und Unterseite des Substrates kann so verzichtet werden. Die Größe der Kontaktflächen definiert die Anzahl der parallel geschalteten Vias. Figur 3 veranschaulicht diesen Sachverhalt.

Das erfindungsgemäße Chip-Trägersubstrat ist auch besonders vorteilhaft im Hinblick auf die Verbindungstechnik. Da platzsparende Face-to-Face Interconnects verwendet werden können, kann der Flächenverbrauch im Gegensatz zu Chip-Trägersubstraten, die durch Drahtbonden mit dem Chip verbunden werden, erheblich reduziert werden.

### Bezugszeichenliste

- 10: Substrat
- 11: erste (vorderseitige) Oberfläche
- 11': Ebene des erstarrten Metalls auf der ersten Oberfläche
- 12: zweite (rückseitige) Oberfläche
- 12': Ebene des erstarrten Metalls auf der zweiten Oberfläche
- 13: Sacklochwand
- 20: Sackloch bzw. Pore
- 21: bereichsweise freigelegtes, nur durch die Isolationsschicht definiertes Sacklochende
- 22: Durchgangsloch
- 30: Isolatorschicht
- 40: Metall oder Metalllegierung, erstarrt oder Schmelze
- 50: Leiterbahn
- 60: Isolator, z.B. Polyimid
- 70: Oberfläche
- 80: Leiterbahn
- 90: Standard Flip Chip Interconnect
- 92: Face-to-Face Interconnect
- 94: Chip

## Patentansprüche

1. Verfahren zur Herstellung eines mit Metall oder einer Legierung befüllten Substrats (10) auf Basis von makroporösem Silizium, das als Träger für mikroelektronische Bauteile, insbesondere Chips, geeignet ist, umfassend die Schritte:
(i) Erzeugen von Sacklöchern (20) mit einer Tiefe im Bereich von 25 bis 1000 µm und einem Durchmesser im Bereich von 5 bis 150 µm von der ersten, vorderseitigen Oberfläche (11) eines Siliziumsubstrats aus,
(ii) Erzeugen einer Isolatorschicht (30) auf den Oberflächen (11,12) des in Schritt (i) erhaltenen Substrats,
(iii) selektives isotropes Ätzen von der zweiten, rückseitigen Oberfläche (12) aus unter Freilegen der in Schritt (ii) erzeugten Sacklöcherenden (21) derart, dass die jeweiligen Sacklöcherwände (13), welche durch die in Schritt (ii) erzeugte Isolatorschicht (30) gebildet werden, auf der rückseitigen Oberfläche (12) aus dem Substrat herausragen und in diesem Bereich nur durch die, die jeweilige Sacklochwand bildende Isolatorschicht (30) definiert werden,
(iv) Erzeugen einer weiteren Isolatorschicht (30) auf den Oberflächen des in Schritt (iii) erhaltenen Substrats,
(v) Befüllen mindestens einer Vielzahl der Sacklöcher (20) mit Metall oder einer Metalllegierung durch Einbringen des in Schritt (iii) bzw. (iv) erhaltenen Substrats in eine Schmelze davon unter Druck in einer die Schmelze enthaltenden Prozesskammer,
(vi) asymmetrisches Abkühlen der Schmelze in den Sacklöchern von der vorderseitigen Oberfläche (11) aus, so dass eine Kontraktion des Metalls oder der Legierung beim Abkühlen in den Sacklöchern zur rückseitigen Oberfläche (12) hin erfolgt, bis die erstarrte Metalloberfläche (12') auf einer Ebene mit der rückseitigen Oberfläche (12) des Substrats liegt, und
(vii) Entfernen der übrigen unbefüllten, aus dem Substrat herausragenden und in diesem Bereich nur durch die Isolatorschicht gebildeten Sacklöcherenden (21).

2. Verfahren gemäß Anspruch 1, worin das Erzeugen der Sacklöcher in Schritt (i) mittels elektrochemischem Ätzen, reaktivem Ionenätzen oder Laserbohren erreicht wird.

3. Verfahren gemäß Anspruch 1 oder 2, worin das Erzeugen der Isolatorschicht (30) in Schritt (ii) durch thermische Oxidation des Siliziumsubstrats bewirkt wird.

4. Verfahren gemäß einem der Ansprüche 1 bis 3, worin in Schritt (iii) die Isolatorschicht (30) von der zweiten rückseitigen Oberfläche durch naß- oder trockenchemisches Ätzen entfernt und anschließend das Silizium einseitig, vorzugsweise naßchemisch mittels KOH oder TMAH, geätzt wird.

5. Verfahren gemäß einem der Ansprüche 1 bis 4, worin in Schritt (v) das Substrat in die Schmelze getaucht, und die Prozeßkammer mit Druck im Bereich von 1 bis 20 bar, vorzugsweise im Bereich von 5 bis 10 bar, beaufschlagt wird.

6. Verfahren gemäß Anspruch 5, wobei die Schmelze eine Aluminiumschmelze ist.

7. Verfahren gemäß einem der Ansprüche 1 bis 6, worin in Schritt (v) hochreiner trockener Stickstoff oder ein hochreines trockenes Edelgas als Prozessgas in der Prozesskammer zum Erzeugen des Druckes beim Füllen mit flüssigem Metall verwendet wird.

8. Verfahren gemäß einem der Ansprüche 1 bis 7, worin in Schritt (vi), nachdem das Substrat aus der Schmelze gezogen worden ist, die Abkühlung der ersten Oberfläche (11) durch eine der Oberfläche gegenüberliegende wassergekühlte Metallplatte beschleunigt wird oder die Abkühlung der Schmelze von der Rückseite des Substrates (12) her durch eine Lampenheizung oder eine beheizte Metalloberfläche verhindert bzw. verlangsamt wird, so dass die Erstarrung des Metalls in den Poren jeweils von der Vorderseite (11) zur Rückseite (12) hin erfolgt.

9. Verfahren gemäß einem der Ansprüche 1 bis 8, worin in Schritt (vii) das Entfernen mittels nass- oder trockenchemischer Ätzung erfolgt.

10. Mit Metall oder einer Legierung befülltes Substrat (10) auf Basis von makroporösem Silizium, geeignet als Träger für mikroelektronische Bauteile, insbesondere Chips, wobei das Substrat gegenüberliegend eine erste und zweite Oberfläche (11, 12) aufweist, wobei über den gesamten Oberflächenbereich verteilt eine Vielzahl von diskreten Durchgangslöchern (22) mit einem Durchmesser im Bereich von 5 bis 150 µm angeordnet ist, wobei die Oberflächen (11,12) und die Innenwände (13) der Durchgangslöcher des Substrats von einer Isolatorschicht (30) bedeckt sind, und wobei die Durchgangslöcher (22) vollständig mit Metall oder einer Metalllegierung (40) befüllt sind, so daß die metallgefüllten Durchgangslöcher (22,40) als Vias die Metallisierungsebenen der ersten und zweiten Oberfläche (11,11',12,12') elektrisch miteinander kontaktieren, wobei sowohl die Kontakte jeweils voneinander elektrisch isoliert sind als auch jeder Kontakt elektrisch gegen das Substrat (10) isoliert ist.

11. Substrat gemäß Anspruch 10, wobei das Metall (40) zur Befüllung der Durchgangslöcher (22) aus Aluminium oder einer Legierung davon mit Silizium und/oder Kupfer ausgewählt ist.

12. Substrat gemäß Anspruch 10 oder 11, wobei die metallgefüllten Durchgangslöcher (22,40) als Vias ein Aspektverhältnis im Bereich von 1:5 bis 1: 50 aufweisen.

13. Substrat gemäß einem der Ansprüche 10 bis 12, wobei die Dichte der befüllten Durchgangslöcher (22,40) im Bereich von 10⁴ bis 10⁶/cm² liegt.

14. Substrat gemäß einem der Ansprüche 10 bis 13, wobei die Dicke des Substrats zwischen 25 bis 1000 µm, vorzugsweise 100 bis 250 µm beträgt.

15. Substrat gemäß einem der Ansprüche 10 bis 14, wobei die Isolatorschicht (30) auf Basis von SiO₂ oder Si₃N₄ ist.

16. Substrat gemäß einem der Ansprüche 10 bis 15, wobei die Dicke der Isolatorschicht 10 bis 2000 nm beträgt.

17. Verwendung des Substrats gemäß einem der Ansprüche 10 bis 16 als Träger für ein oder mehrere mikroelektronische Bauteile, insbesondere Chips, auf einer oder beiden Substrat-Oberflächenseiten.
